# EUROPÄISCHE PATENTANMELDUNG

(11) **EP 2 073 615 A1**
(43) Veröffentlichungstag der Anmeldung: **24.06.2009**
(21) Anmeldenummer: 08017970.8
(22) Anmeldetag: 14.10.2008
(51) Int. Cl.: H05K 3/38, H05K 3/34, H05K 3/26, H05K 3/28, H05K 3/12, H05K 3/24, B05D 7/00, B05D 3/14, B05D 1/00

(54) **Verfahren zur selektiven Beschichtung einer Oberfläche mit Flüssigkeit**

(30) Priorität: 20.12.2007 DE 102007061465
(71) Anmelder: Fraunhofer-Gesellschaft zur Förderung der angewandten Forschung e.V., 80686 München (DE)
(72) Erfinder: Yacoub-George, Erwin, 81929 München (DE); Scherbaum, Sabine, 81241 München (DE); Landesberger, Christof, 82166 Gräfelfing (DE)
(74) Vertreter: Grünecker, Kinkeldey, Stockmair & Schwanhäusser Anwaltssozietät

(57) **Zusammenfassung**

Die vorliegende Erfindung betrifft ein Verfahren zur selektiven Beschichtung einer Oberfläche eines Substrates mit Flüssigkeit, wobei die mit der Flüssigkeit selektiv zu beschichtende Oberfläche Bereiche mit unterschiedlichen Oberflächenenergien aufweist, und wobei vor der Benetzung ein Fluor-haltiges Plasmagas auf die Bereiche mit unterschiedlichen Oberflächenenergien unmittelbar einwirkt.

## Beschreibung

Die vorliegende Erfindung betrifft ein Verfahren zur selektiven Beschichtung einer Oberfläche mit Flüssigkeit. Insbesondere betrifft die vorliegende Erfindung auch eine selektive Oberflächenmodifikation von metallstrukturierten Kunststofffolien mittels Plasmaprozessen.

Die gezielte Auftragung von Flüssigkeit auf bestimmte Bereiche einer Festkörperoberfläche, z.B. die Auftragung von Klebepunkten, erfolgt in der industriellen Fertigung in der Regel mittels Dosierautomaten. Diese Dosierautomaten weisen eine X,Y- Positioniereinheit in Verbindung mit einer Dosiereinheit auf, wodurch die Flüssigkeit mittels der Dosiereinheit abgemessen und mittels der X,Y- Positioniereinheit gezielt und vollautomatisiert in die vordefinierten Bereiche aufgebracht werden kann.

Für Anwendungen, in denen kleinste Flüssigkeitsmengen dosiert und/oder sehr viele Flüssigkeitsspots gesetzt werden müssen, erreichen solche roboter-basierten Lösungen jedoch ihre technischen und wirtschaftlichen Grenzen.

Aus U. Srinivasan, D. Liepmann, R.T. Howe, "Microstructure to Substrate Self-Assembly Using Capillary Forces", Journal of Microelektromechanical Systems, Vol. 10, 2001, p. 17-24 ist bekannt, Flüssigkeiten lokalisiert auf Festkörperoberflächen aufzubringen durch die Definition von Bereichen mit unterschiedlichen Benetzungsverhalten, so dass auf die gezielte Zudosierung von Flüssigkeiten mittels Dosierautomaten verzichtet werden kann.

Voraussetzung hierfür ist, dass ein Unterschied im Benetzungsverhalten zwischen verschiedenen Bereichen auf der Oberfläche ausreichend groß ist. Dabei ist zu berücksichtigen, dass das Benetzungsverhalten an der Oberfläche von der Grenzflächenenergie der jeweiligen Flüssigkeit, sowie von der Oberflächenenergie des Festkörpers abhängt. Die Unterschiede in den Oberflächenenergien zwischen den verschiedenen Oberflächenbereichen des Festkörpers müssen also auf die zu dosierende Flüssigkeit abgestimmt sein, wenn der oben beschriebene Effekt erzielt werden soll.

Werden Festkörperoberflächen, die ausgeprägte Unterschiede im Benetzungsverhalten zeigen, ganzflächig mit einer Flüssigkeit benetzt (z.B. durch Sprühen, Rakeln oder Tauchen), so ordnet sich die Flüssigkeit bevorzugt auf den Bereichen an, die von der Flüssigkeit gut benetzbar sind. Demgegenüber perlt die Flüssigkeit von den Bereichen mit schlechter Benetzbarkeit leichter ab. Auf diese Weise ist es möglich, z.B. Klebstoffe gezielt auf bestimmte Stellen einer Folienoberfläche aufzubringen, ohne dass hierzu ein spezieller Dosierautomat (Dispenser) eingesetzt werden muss.

Plasmaprozesse sind sehr gut geeignet, um das Benetzungsverhalten von Kunststoffoberflächen einzustellen.

Durch eine geeignete Maskentechnik können mittels Plasmaprozessen auf einer Kunststoffoberfläche gezielt Bereiche mit unterschiedlichen Benetzungsverhalten erzeugt werden, wie aus A. Ohl, K. Schröder "Plasma-induced chemical micropatterning for cell culturing applications: a brief review", Surface and Coatings Technology 116-119(1999) 820-830) und aus N.A. Bullett, D.P. Bullett, F.E. Truica-Marasescu, S. Lerouge. F. Mwale, M.R. Wertheimer " Polymer surface micropatterning by plasma and VUVphotochemical modification for controlled cell culture", Applied Surface Science 235 (2004), 395-405 bekannt.

Hierzu wird die Kunststoffoberfläche zunächst vollflächig, z.B. mit einem hydrophiliserenden Plasma, behandelt. Anschließend wird eine entsprechend strukturierte Maske, z.B. aus einer Adhäsisionsfolie, aus einer Metallfolie oder einer Fotolithographiemaske auf diese hydrophilisierte Kunststoffoberfläche aufgebracht. Wirkt jetzt ein hydrophobisierendes Plasma auf diese vorher hydrophilisierte und von der strukturierten Maske teilweise abgedeckte Kunststoffoberfläche, so werden nur diejenigen Bereiche auf der Kunststoffoberfläche hydrophobisiert, welche nicht von der Maske überdeckt sind. Im letzten Schritt muss die Maske wieder entfernt werden. Anschließend weist diese derart behandelte Kunststoffoberfläche im Idealfall scharf definierte Bereiche mit unterschiedlichen Benetzungsverhalten auf.

Diese Technologie weist jedoch zwei wesentliche Nachteile auf, welche eine kommerzielle Anwendung erschweren.

So muss ein sehr enger Kontakt zwischen strukturierter Maske und Substratoberfläche bestehen, um das Plasma wirkungsvoll auf die nicht abgedeckten Bereich zu begrenzen und um die gewünschten scharfen Grenzlinien zu erreichen. Dieses zu erreichen ist sowohl bei großen Flächen des Substrates als auch bei sehr feinen Strukturen, insbesondere mit Adhäsionsfolien oder Metallfolienmasken, schwierig zu erreichen. Desweiteren wird das Benetzungsverhalten der Substratoberfläche durch die Maske bzw. durch die Prozessschritte zum Aufbringen bzw. zum Entfernen der Maske (z.B. der Fotolithographiemaske) mehr oder weniger stark beeinflusst.

Aus diesen Nachteilen ergibt sich, dass sich die Oberflächenenergien der zu strukturierenden Bereiche bei Anwendung solcher maskenbasierter Verfahren in der Praxis nur schwer kontrollieren lassen.

Aus J. Seo, E. Ertekin, M.S. Pio, L.P. Lee, "Self-Assembly Templates by Selective Plasma Surface Modification of Micropatterned Photoresist", 2002 IEEE ist ein weiteres Verfahren bekannt, wie sich hydrophile und hydrophobe Bereiche auf einer Oberfläche eines teilweise mit Photolack bedeckten Si- oder SiO₂-Wafers erzeugen lassen. Zunächst wird der Wafer einschließlich des Photolacks mittels eines O₂-Plasmas hydrophilisiert. Durch anschließendes Einwirken eines CF₄- oder SF₆-Plasmas gelingt eine Hydrophobisierung der Fotolackoberfläche, wohingegen die Si- bzw. SiO₂-Oberflächen einen solchen Effekt nicht zeigen und hydrophilisiert bleiben.

Es ist eine Aufgabe der vorliegenden Erfindung, ein Verfahren zur selektiven Beschichtung einer Oberfläche eines Substrates mit Flüssigkeit anzugeben, welches keine Maskentechnik benötigt, um eine selektive Benetzung der Strukturen zu bewirken und welches insbesondere auf eine Photolackschicht verzichten kann.

Die vorgenannte Aufgabe wird erfindungsgemäß gelöst durch ein Verfahren zur selektiven Beschichtung einer Oberfläche eines Substrates mit Flüssigkeit, wobei die mit der Flüssigkeit selektiv zu beschichtende Oberfläche Bereiche mit unterschiedlichen Oberflächenenergien aufweist, und wobei vor der Benetzung ein Fluor-haltiges Plasmagas auf die Bereiche mit unterschiedlichen Oberflächenenergien unmittelbar einwirkt. Dabei weist das Substrat zumindest einen Bereich mit einer Kunststoffoberfläche und zumindest einen Bereich mit einer Metalloberfläche oder einer anorganischen Oberfläche auf, wobei das Fluor-haltige Plasmagas auf diese Bereiche unmittelbar einwirkt, wodurch die Kunststoffoberfläche hydrophobisiert und die metallische bzw. die anorganische Oberfläche hydrophilisiert werden.

Bei der erfindungsgemäßen Lösung wirkt das Fluor-haltige Plasma vollflächig auf die gesamte Oberfläche des Substrates, d.h. es wirkt unmittelbar auf die Oberfläche, so dass keine Maskentechnik benötigt wird, um eine selektive Benutzung der Strukturen zu bewirken. Es wird insbesondere auch keine Photolackschicht benötigt. Diese Photolackschicht wäre als Schicht im Aufbau eines elektronischen Bauteils zumeist störend, da sie nicht dauerhaft stabil ist.

Das Substrat kann hierbei eine metallstrukturierte Kunststofffolie sein, dessen Oberfläche mit dem Fluor-haltigen Plasmagas behandelt wird. In der Anwendung des vorliegenden Verfahrens auf Kunststofffolien ist eine Nutzung des Verfahrens für selbstgesteuerte Beschichtungsprozesse bei der Herstellung von elektrischen Schaltungen auf insbesondere flexiblen Substraten ermöglicht.

Das Substrat kann außerdem ein Kunststoffsubstrat sein, an dessen mit Flüssigkeit selektiv zu beschichtender Oberfläche strukturierte Metallflächen vorliegen. Das Substrat kann ebenso aus einem beliebigen Werkstoff vorgesehen werden, wobei dieses Substrat ein- oder beidseitig mit einer Kunststoffschicht überzogen ist, auf dessen mit Flüssigkeit selektiv zu beschichtende Oberfläche ein- oder beidseitig Metallstrukturen ausgebildet sind. Das Substrat kann ebenso aus einem beliebigen Werkstoff vorgesehen werden, wobei das Substrat mit Metall beschichtet ist, welches seinerseits von einer Kunststoffschicht überzogen ist, welche definierte Öffnungsstrukturen aufweist. Das Substrat kann ebenfalls aus einer Metallfolie vorgesehen werden, das ein- oder beidseitig mit einer Kunststoffschicht überzogen ist, die definierte Öffnungsstrukturen aufweist.

Gemäß einem weiteren bevorzugten Ausführungsbeispiel wirkt auf die zu beschichtende Oberfläche ein CF₄-Plasma, ein SF₃-Plasma, ein SF₆-Plasma oder Mischungen eines dieser Plasmen mit Sauerstoff oder Stickstoff, insbesondere ein F/C/O₂-Plasma, vorzugsweise aus 60 Vol.-% CF₄ und 40 Vol.-% O₂ oder aus 80 Vol.-% CF₄ und 20 Vol.-% O₂ ein.

Das Plasma kann als ein Niederdruckplasma, vorzugsweise bei einem Kammerdruck von 0,1 bis 100 mbar, auf die Oberfläche einwirken oder kann als Atmosphärenplasma bei Normaldruck auf die Oberfläche einwirken.

Die Plasmaeinwirkung kann weiterhin in einem durchlaufenden Prozess durchgeführt werden, und auch ein Auftrag der Flüssigkeit auf die plasmabehandelte Oberfläche kann in einem durchlaufenden Prozess erfolgen.

Als Flüssigkeit für die selektive Benetzung können Wasser, Lösemittel, Lacke, elektrisch isolierende oder leitende Polymere, leitfähige Tinten oder dünnflüssige Klebstoffe genutzt werden.

Die Plasmaeinwirkung kann insbesondere als Vorbereitungsschritt für einen sich selbst steuernden Beschichtungs-Prozess bei der Herstellung von elektrischen Schaltungen auf einem insbesondere flexiblen Substrat verwendet werden.

Die Flüssigkeit für die selektive Benetzung kann ebenfalls Feststoffe und/oder funktionelle Komponenten enthalten, so dass die Plasmaeinwirkung als Vorbereitungsschritt für eine sich selbst steuernde Assemblierung von kleinen Objekten oder Komponenten genutzt werden kann.

Weitere Aufführungsformen sind Gegenstand weiterer abhängiger Ansprüche.

Die vorliegende Erfindung wird nachfolgend anhand bevorzugter Ausführungsbeispiele in Verbindung mit der zugehörigen Zeichnung näher erläutert.

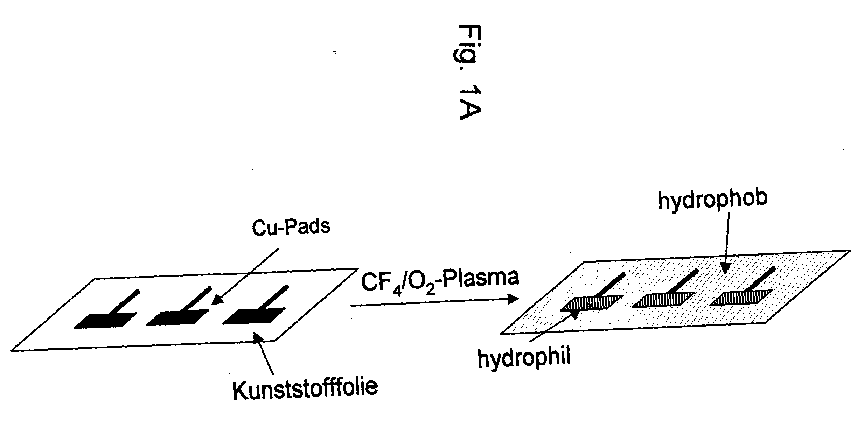

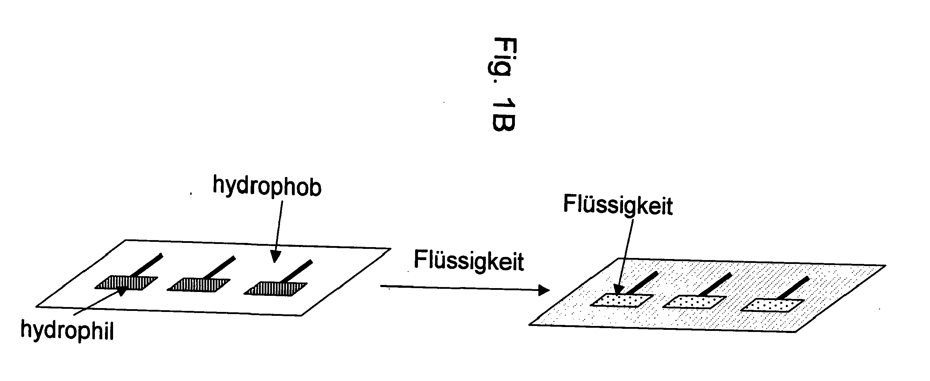

Fig. 1A und Fig. 1B zeigen schematisch ein bevorzugtes Ausführungsbeispiel des Verfahrens zur selektiven Beschichtung einer Oberfläche eines Substrats.

Die Benetzbarkeit von Oberflächen durch bestimmte Flüssigkeiten wird üblicherweise durch den Kontaktwinkel eines Flüssigkeitstropfens auf der Oberfläche charakterisiert. Kleine Kontaktwinkel bedeuten hierbei, dass der Flüssigkeitstropfen sich ausbreitet, die Benetzung ist also sehr gut. Große Kontaktwinkel bedeuten hingegen, dass der Flüssigkeitstropfen stehenbleibt, so dass im Querschnittsbild sehr große Winkel zwischen Substratoberfläche und Tropfenoberfläche entstehen, die Benetzbarkeit ist also schlecht.

In Experimenten wurden folgende Werte der Benetzbarkeit von Wassertropfen auf Oberflächen aus Gold, Aluminium, Kupfer, Silizium, PET (Polyethylenternaphtalat) und Polyimid nach unterschiedlicher Plasmabehandlung entsprechend nachfolgender Tabelle gefunden.

| **Oberflächen** | **Kontaktwinkel eines Wassertropfens nach CF₄/O₂-Plasmaeinwirkung auf der jeweiligen Oberfläche** | **Kontaktwinkel eines Was-sertropfens nach O₂/N₂-Plasmaeinwirkung auf der jeweiligen Oberfläche** |
|---|---|---|
| Gold, Kupfer, Aluminium | 0 - 10° | 0 - 10° |
| Silizium | 40 - 60° | 0 - 10° |
| Siliziumdioxid | 40 - 50° | 0 - 10° |
| Siliziumnitrid | 40 - 50° | 0 - 10° |
| PET | 100 - 110° | 0 - 10" |
| Polyimid | 100 - 110° | 0 - 10° |

Aus den Werten dieser Tabelle ist ersichtlich, dass die aufgeführten Oberflächen aus Kunststoff, Metallen, Halbleitern und Isolatoren nach Einwirkung eines Sauerstoff/Stickstoff-Plasmas generell sehr hydrophil werden.

Dagegen führt eine Einwirkung eines CF₄/O₂-Plasmas zu sehr unterschiedlichen Kontaktwinkeln auf den verschiedenen Materialien. Eine maximale Selektivität der Benetzbarkeit wird, wie aus der Tabelle ersichtlich, nach Einwirkung des CF₄/O₂-Plasmas zwischen Metallen (Gold, Kupfer, Aluminium) und den Kunststoffoberflächen aus Polyimid und PET erzielt.

Aus diesen experimentellen Daten lässt sich ableiten, dass eine vollflächige Plasmaeinwirkung auf eine Oberfläche, die zumindest einen Bereich aus Kunststoff und zumindest einen Bereich aus Metall aufweist, einen maximalen Unterschied in der Benetzbarkeit von Wasser ergibt.

Gemäß der vorliegenden Lehre wird dieser Effekt der Benetzbarkeit genutzt, um eine Oberfläche so mit einer Flüssigkeit zu beschichten, dass nur die Metallstrukturen mit der Flüssigkeit benetzt werden. Dieser Effekt der Benetzbarkeit kann ebenso genutzt werden, um eine Oberfläche selektiv mit Flüssigkeit zu beschichten, die zumindest einen Bereich aus Kunststoff und zumindest einen Bereich aus anorganischem Material aufweist.

In Figur 1A und Fig. 1B sind die Grundzüge dieses Verfahrens am Beispiel von einer Polyimidfolie (PI-Folie) mit auf der Oberfläche der PI-Folie angeordneten Kupfer-Pads (Cu-Pads) gezeigt.

Hierbei zeigt Fig. 1A die Behandlung der strukturierten Metalloberfläche mit der Polyimidfolie mit dem CF₄/O₂-Plasma, wodurch sich die unterschiedlichen hydrophilen und hydrophoben Bereiche ergeben und Fig. 1B zeigt die nachfolgende Beschichtung mit Flüssigkeit, wodurch sich die Flüssigkeit in den hydrophilen Bereichen (Cu-Pads) anlagert, da diese sehr viel besser benetzbar sind.

Durch die Behandlung mit einem CF₄/O₂-Plasma oder alternativ mit einem CF₄-Plasma (bzw. mit einem anderen Fluor-haltigen Plasma) wird die PI-Folie hydrophob und die Cu-Pads hydrophil. Es entstehen somit auf der Oberfläche der PI-Folie Bereiche unterschiedlicher Oberflächenenergie, also hydrophobe und hydrophile Bereiche, wodurch ein maximaler Unterschied im Benetzungsverhalten erreicht wird, der dann für Beschichtungsprozesse ausgenutzt wird.

Mittels des vorliegenden Verfahrens lassen sich Kunststoffoberflächen durch unmittelbare Einwirkung eines Fluor-haltigen Plasmagases (CF₄/O₂-Plasma oder CF₄-Plasma) direkt chemisch modifizieren. Demgegenüber beobachtet man bei anorganischen Oberflächen und genauso bei Metallen bei Einwirkung eines Fluor-haltigen Plasmas in erster Linie eine Reinigungswirkung infolge eines Plasmaätzprozesses. Dementsprechend führt das Einwirken des Fluor-haltigen Plasmas auf der Kunststoffoberfläche zu einer Hydrophobisierung der Oberfläche, wohingegen metallische Oberflächen bzw. anorganische Oberflächen durch das Fluor-haltige Gas im wesentlichen nur gereinigt werden, wodurch die Hydrophilie der Metalloberfläche bzw. der anorganischen Oberfläche maximiert wird.

Befinden sich nun auf einer Kunststoffoberfläche (z.B. einer Kunststofffolie) strukturierte metallische Bereiche (z.B. Leiterbahnen), so liegen an der Oberfläche Bereiche mit Kunststoffoberfläche neben Bereichen mit metallischer Oberfläche. Die Einwirkung eines Fluor-haltigen Plasmas (z.B. CF₄-Plasma) bewirkt, dass die nicht-metallischen Bereiche (die Kunststoffbereiche) hydrophobisiert werden und die metallischen Bereiche (die Leiterbahnen) hydrophilisiert bleiben. Hierdurch gelingt es, auf metallstrukturierten Kunststofffolien, wie sie z.B. in der flexiblen Elektronik eingesetzt werden, Bereiche zu schaffen, die sehr gut (die metallischen Strukturen) und sehr schlecht (der Kunststoff) benetzen, ohne dass hierfür eine aufwendige Maskentechnik notwendig wäre. Und eben dieser Effekt kann zur Beschichtung dieser Kunststofffolien verwendet werden.

Gemäß dem vorliegenden Ausführungsbeispiel wirkt das Fluor-haltige Plasma (CF₄-Plasma bzw. CF₄/O₂-Plasma) (voll-)flächig und unmittelbar auf die gesamte Kunststofffolie ein. Die organischen Oberflächen der Kunststofffolie werden hydrophobisiert, die anorganischen bzw. metallischen Oberflächen werden hydrophilisiert.

Gemäß dem beschriebenen bevorzugten Ausführungsbeispiel ist also als Substrat ein Kunststoffsubstrat vorgesehen, an dessen zu behandelnden Oberflächen strukturierte Metallflächen vorliegen, wobei das Plasma vollflächig und direkt auf die gesamte Oberfläche wirkt, so dass auf eine aufwendige Maskentechnik verzichtet werden kann. Das Substrat kann dabei starr oder flexibel sein. Die Metallstrukturen können beispielsweise Kupfer, Aluminium oder auch Edelmetalle sein.

Gemäß einem alternativen Ausführungsbeispiel kann das Substrat jedoch auch aus einem beliebigen Werkstoff bestehen, der ein- oder beidseitig mit einer Kunststoffschicht überzogen ist, wobei an der Oberfläche der Kunststoffschicht ein- oder beidseitig des Substrates Metallstrukturen ausgebildet sind.

Gemäß einem weiteren alternativen Ausführungsbeispiel ist das Substrat aus einem beliebigen Werkstoff gebildet, der mit Metall beschichtet ist, wobei das Metall seinerseits von einer Kunststoffschicht überzogen ist, und wobei diese Kunststoffschicht definierte Öffnungsstrukturen aufweist.

Das Substrat kann ebenfalls eine Metallfolie sein, die ein- oder beidseitig mit Kunststoff beschichtet ist, wobei diese Kunststoffschicht wiederum definierte Öffnungsstrukturen aufweist.

Die Herstellung der Metallstrukturen kann entweder über einen klassischen LithographieProzess, wie er aus der Leiterplattenherstellung bekannt ist, erfolgen. Alternativ können die Metallstrukturen mittels Drucktechnik strukturiert auf die Folie oder das Kunststoff-Substrat aufgebracht werden (Ink-Jet oder Siebdruck).

Das vorliegende Verfahren kann als ein Niederdruckplasmaverfahren ausgebildet sein, die Plasmaeinwirkung kann also bei einem Kammerdruck von 0,1 bis 100 mbar durchgeführt werden. Ebenso ist eine Verwendung als Atmosphärenplasma möglich, das bei Normaldruck an der Substratoberfläche einwirkt.

Als Plasmagase kommen Fluor-haltige Gase in Betracht, z.B. CF₄, SF₃, SF₆ oder auch Mischungen derselben mit Sauerstoff oder Stickstoff. Besonders vorteilhaft hat sich eine Mischung aus 60 Vol.-% CF₄ und 40 Vol.-% O₂ oder 80 Vol.-% CF₄ und 20 Vol.-% O₂ erwiesen.

Als Flüssigkeit für die selektive Benetzung können Wasser, Lösungsmittel, Lacke, elektrisch isolierende oder leitende Polymere und dünnflüssige Klebstoffe, etc. verwendet werden. Darüber hinaus können Flüssigkeiten aufgetragen werden, die Feststoffe bzw. funktionale Komponenten enthalten, wobei in dieser Verfahrensvariante das vorliegende Verfahren als ein Teilschritt zur selbstgesteuerten Assemblierung ("self assembly") von kleinen Objekten oder Komponenten genutzt werden kann.

Die Beschichtung des Foliensubstrats kann in einem durchlaufenden Verfahren durchgeführt werden. In diesem Fall wird nach der ganzflächigen Plasmabehandlung das Substrat mit einer Flüssigkeit in Kontakt gebracht. Dies kann durch Eintauchen, RakelBeschichtung, Dispensen oder Drucken erfolgen.

Eine weitere Anwendungsmöglichkeit besteht im selektiven und selbstgesteuerten Aufbringen einer Klebstoffschicht auf eine Oberfläche. Dies kann beispielsweise genutzt werden, um elektrische oder elektronische Bauteile zu platzieren.

Eine weitere Anwendungsmöglichkeit besteht im Verkleben von Substraten mit strukturierten Oberflächen, beispielsweise Wafer-to-Wafer-Verbindungsprozesse ("waferbonding") mit einer strukturierten Klebeschicht. Besonders vorteilhaft hierbei ist, dass auch mikrostrukturierte Klebelinien bzw. Klebeflächen automatisch und selektiv mit Klebstoff beschichtet werden können. Es ist also keine aufwendige computergesteuerte Dosiervorrichtung erforderlich.

Eine weitere Anwendungsmöglichkeit besteht in der Beschichtung von großvolumigen Objekten, insbesondere mit dreidimensional geformten Oberflächen.

Eine weitere Anwendungsmöglichkeit besteht im selektiven Auftragen von Flüssigkeiten, welche Feststoffe bzw. funktionale Komponenten enthalten. In dieser Variante kann das vorliegende Verfahren als ein Teilschritt zur selbstgesteuerten Assemblierung ("self assembly") von kleinen Objekten oder Komponenten genutzt werden.

Vorteilhaft im vorliegenden Verfahren ist, dass das Plasma unmittelbar und bevorzugt vollflächig auf die gesamte Oberfläche des Substrates wirken kann. Somit kann auf die Verwendung einer Maskentechnik verzichtet werden, um eine selektive Benetzung der Strukturen zu bewirken. Auch wird insbesondere keine Fotolackschicht benötigt. Diese wäre als Schicht im Aufbau eines elektronischen Bauteils zumeist störend, da sie nicht dauerhaft stabil ist.

Zudem ist das vorliegende Verfahren auch auf Kunststofffolien anwendbar. Dies ermöglicht die Nutzung des neuen Verfahrens für selbstgesteuerte Beschichtungsprozesse bei der Herstellung von elektronischen Schaltungen auf flexiblen Substraten.

Desweiteren kann die unmittelbare Plasmaeinwirkung auch für durchlaufende Prozesse (Rolle zu Rolle, "roll to roll") eingesetzt werden.

## Patentansprüche

1. Verfahren zur selektiven Beschichtung einer Oberfläche eines Substrates mit Flüssigkeit, wobei die mit der Flüssigkeit selektiv zu beschichtende Oberfläche Bereiche mit unterschiedlichen Oberflächenenergien aufweist, und wobei vor der Benetzung ein Fluor-haltiges Plasmagas auf die Bereiche mit unterschiedlichen Oberflächenenergien unmittelbar einwirkt, wobei das Substrat zumindest einen Bereich mit einer Kunststoffoberfläche und zumindest einen Bereich mit einer Metalloberfläche oder einer anorganischen Oberfläche aufweist, und wobei das Fluor-haltige Plasmagas auf diese Bereich unmittelbar einwirkt, wodurch die Kunststoffoberfläche hydrophobisiert und die metallische oder die anorganische Oberfläche hydrophilisiert werden.

2. Verfahren zur selektiven Beschichtung einer Oberfläche mit Flüssigkeit nach Patentanspruch 1, wobei das Substrat eine metallstrukturierte Kunststofffolie ist, dessen Oberfläche mit dem Fluor-haltigen Plasmagas behandelt wird.

3. Verfahren zur selektiven Beschichtung einer Oberfläche mit Flüssigkeit nach Patentanspruch 1, wobei das Substrat ein Kunststoffsubstrat ist, an dessen mit Flüssigkeit selektiv zu beschichtender Oberfläche strukturierte Metallflächen vorliegen.

4. Verfahren zur selektiven Beschichtung einer Oberfläche mit Flüssigkeit nach Patentanspruch 1, wobei das Substrat aus einem beliebigen Werkstoff vorgesehen wird, das ein- oder beidseitig mit einer Kunststoffschicht überzogen ist, auf dessen mit Flüssigkeit selektiv zu beschichtender Oberfläche ein- oder beidseitig Metallstrukturen ausgebildet sind.

5. Verfahren zur selektiven Beschichtung einer Oberfläche mit Flüssigkeit nach Patentanspruch 1, wobei das Substrat aus einem beliebigen Werkstoff vorgesehen wird, das mit Metall beschichtet ist, welches seinerseits von einer Kunststoffschicht überzogen ist, die definierte Öffnungsstrukturen aufweist.

6. Verfahren zur selektiven Beschichtung einer Oberfläche mit Flüssigkeit nach Patentanspruch 1, wobei das Substrat aus Metallfolie vorgesehen wird, das ein- oder beidseitig mit einer Kunststoffschicht überzogen ist, die definierte Öffnungsstrukturen aufweist.

7. Verfahren zur selektiven Beschichtung einer Oberfläche mit Flüssigkeit nach einem der Patentansprüche 1 bis 6, wobei auf die zu beschichtende Oberfläche ein CF₄-Plasma, ein SF₃-Plasma, ein SF₆-Plasma oder Mischungen eines dieser Plasmen mit Sauerstoff oder Stickstoff, insbesondere ein F/C/O₂-Plasma, vorzugsweise aus 60 Vol % CF₄ und 40 Vol.-% O₂ oder 80 Vol.-% CF₄ und 20 Vol.-% O₂ einwirkt.

8. Verfahren zur selektiven Beschichtung einer Oberfläche mit Flüssigkeit nach einem der Patentansprüche 2 bis 7, wobei die Metallstrukturen in einem LithographieProzess oder mittels Drucktechnik strukturiert auf die Folie oder das Kunststoffsubstrat aufgebracht werden.

9. Verfahren zur selektiven Beschichtung einer Oberfläche mit Flüssigkeit nach einem der Patentansprüche 1 bis 8, wobei das Plasma als ein Niederdruckplasma, vorzugsweise bei einem Kammerdruck von 0,1 bis 100 mbar, auf die Oberfläche einwirkt, oder wobei das Plasma als ein Atmosphärenplasma bei Normaldruck auf der Oberfläche einwirkt.

10. Verfahren zur selektiven Beschichtung einer Oberfläche mit Flüssigkeit nach einem der Patentansprüche 1 bis 9, wobei die Plasma-Einwirkung in einem durchlaufenden Prozess durchgeführt wird.

11. Verfahren zur selektiven Beschichtung einer Oberfläche mit Flüssigkeit nach einem der Patentansprüche 1 bis 10, wobei ein Auftrag der Flüssigkeit auf die plasmabehandelte Oberfläche in einem durchlaufenden Prozess erfolgt.

12. Verfahren zur selektiven Beschichtung einer Oberfläche mit Flüssigkeit nach einem der Patentansprüche 1 bis 11, wobei Wasser, Lösemittel, Lacke, elektrisch isolierende oder leitende Polymere, leitfähige Tinten oder dünnflüssige Klebstoffe als Flüssigkeit für die selektive Benetzung genutzt wird.

13. Verfahren zur selektiven Beschichtung einer Oberfläche mit Flüssigkeit nach einem der Patentansprüche 1 bis 12, wobei die Plasma-Einwirkung als Vorbereitungsschritt für einen sich selbst steuernden BeschichtungsProzess bei der Herstellung von elektrischen Schaltungen auf einem insbesondere flexiblen Substrat verwendet wird.

14. Verfahren zur selektiven Beschichtung einer Oberfläche mit Flüssigkeit nach einem der Patentansprüche 1 bis 13, wobei eine Flüssigkeit, die Feststoffe und/oder funktionale Komponenten enthält, als Flüssigkeit für die selektive Benetzung genutzt wird, so dass die Plasma-Einwirkung als Vorbereitungsschritt für eine sich selbst steuernde Assemblierung von kleinen Objekten oder Komponenten genutzt wird.
